Europäisches Patentamt

European Patent Office

Office européen des brevets

(19)

(11) **EP 1 408 538 A1**

(12) **EUROPEAN PATENT APPLICATION**
published in accordance with Art. 158(3) EPC

(43) Date of publication:
**14.04.2004 Bulletin 2004/16**

(51) Int Cl.7: **H01L 21/304**

(21) Application number: **02743826.6**

(86) International application number:
**PCT/JP2002/006780**

(22) Date of filing: **04.07.2002**

(87) International publication number:
**WO 2003/009362 (30.01.2003 Gazette 2003/05)**

(84) Designated Contracting States:
**AT BE CH CY DE DK ES FI FR GB GR IE IT LI LU MC NL PT SE TR**

(30) Priority: **19.07.2001 JP 2001219431**

(71) Applicant: **Nikon Corporation Tokyo 100-8831 (JP)**

(72) Inventors:
• **HOSHINO, Susumu, Nikon Corporation Tokyo 100-8331 (JP)**

• **UDA, Yutaka, Nikon Corporation Tokyo 100-8331 (JP)**
• **SUGAYA, Isao, Nikon Corporation Tokyo 100-8331 (JP)**

(74) Representative: **Viering, Jentschura & Partner Steinsdorfstrasse 6 80538 München (DE)**

(54) **POLISHING ELEMENT, CMP POLISHING DEVICE AND PRODUCTIONS METHOD FOR SEMICONDUCTOR DEVICE**

(57)    The wafer 11 that is the object of polishing is held by a polishing head 12, and rotates together with the polishing head 12. A polishing body 14 is attached to the polishing member 13 by bonding using an adhesive agent or two-sided adhesive tape, etc. As is shown in (b), the polishing body 14 is constructed by laminating a soft member 15, a hard elastic member 16 and a polishing pad 17. The hard elastic member 16 is constructed so that the amount of deformation of the hard elastic member 16 at the polishing load that is applied during polishing is smaller than the step difference that is permitted in the above-mentioned wafer in the interval corresponding to the maximum pattern of the above-mentioned semiconductor integrated circuits, and is larger than the TTV that is permitted in the above-mentioned wafer in the interval corresponding to one chip. As a result, the requirements of both "wafer global removal uniformity" and local pattern planarity" can be satisfied.

Fig. 2

**Description**

Technical Field

The present invention relates to a CMP polishing apparatus which is used to polish wafers that have semiconductor integrated circuits formed inside, a polishing body which is used in this CMP polishing apparatus, and a semiconductor device manufacturing method which uses this CMP polishing apparatus.

Background Technology

As semiconductor integrated circuits have become finer and more highly integrated, the individual processes involved in semiconductor manufacturing processes have become more numerous and complicated. As a result, the surfaces of semiconductor devices are not always flat. The presence of step differences on the surfaces of semiconductor devices leads to step breakage of wiring and local increases in resistance, etc., and thus causes wiring interruptions and drops in electrical capacitance. In insulating films, furthermore, such step differences also lead to a deterioration in the withstand voltage and the occurrence of leaks.

Meanwhile, as semiconductor integrated circuits have become finer and more highly integrated, the wavelengths of light sources in semiconductor exposure apparatuses used in photolithography have become shorter, and the numerical aperture or so-called NA of the projection lenses used in such semiconductor exposure apparatuses has become larger. As a result, the focal depth of the projection lenses used in such semiconductor exposure apparatuses has become substantially shallower. In order to deal with such increasing shallowness of the focal depth, there is a demand for even greater planarization of the surfaces of semiconductor devices than that achieved so far.

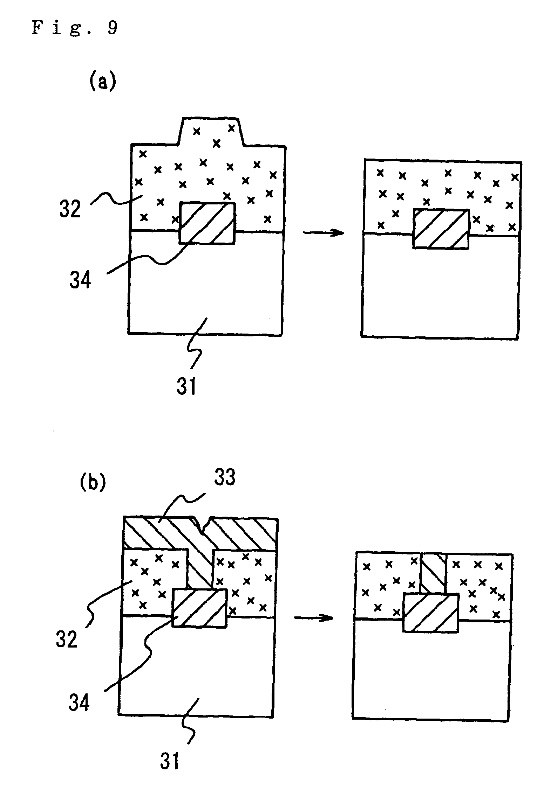

To describe this in concrete terms, planarization techniques such as that shown in Figure 9 have become essential in semiconductor manufacturing processes. Figure 9 is a schematic diagram illustrating planarization techniques used in a semiconductor manufacturing process, and shows sectional views of a semiconductor device. In Figure 9, 31 indicates a silicon wafer, 32 indicates an inter-layer insulating film consisting of $SiO_2$, 33 indicates a metal film consisting of Cu, and 34 indicates the semiconductor device.

Figure 9 (a) shows an example of the planarization of an inter-layer insulating film 32 on the surface of the semiconductor device. Figure 9 (b) shows an example in which a so-called damascene is formed by polishing the metal film 33 on the surface of the semiconductor device. A chemical mechanical polishing or chemical mechanical planarization (hereafter referred to as "CMP") technique is widely used as a method for planarizing the surfaces of such semiconductor devices. Currently, the CMP technique is the sole method that can be used to planarize the entire surface of a silicon wafer.

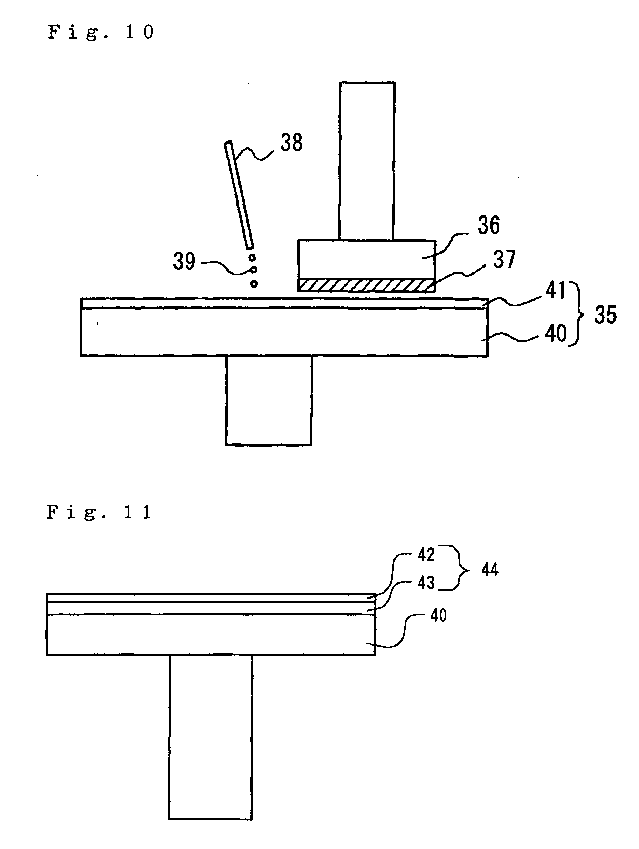

CMP was developed on the basis of silicon wafer mirror surface polishing methods, and is performed using a CMP apparatus of the type shown in Figure 10. In Figure 10, 35 indicates a polishing member, 36 indicates a member that holds the object of polishing (hereafter referred to as a "polishing head" in some instances), 37 indicates a silicon wafer which is the object of polishing, 38 indicates a polishing agent supply part, and 39 indicates a polishing agent. The polishing member 35 has a polishing pad 41 which is attached to the surface of a polishing platen 40. A sheet-form foam polyurethane is widely used as such a polishing pad 41.

The object of polishing 37 is held by the polishing head 36, so that it is caused to oscillate while being rotated, and is pressed against the polishing pad 41 of the polishing member 35 with a specified pressure. The polishing member 35 is also rotated, so that a relative motion is performed between the polishing member 35 and the object of polishing 37. In this state, the polishing agent 39 is supplied to the surface of the polishing pad 41 from the polishing agent supply part 38. The polishing agent 39 diffuses over the surface of the polishing pad 41, and enters the space between the polishing pad 41 and the object of polishing 37 as the polishing member 35 and object of polishing 37 move relative to each other, so that the surface of the object of polishing 37 that is to be polished is polished. Specifically, good polishing is accomplished by a synergistic effect of the mechanical polishing caused by the relative motion of the polishing member 35 and object of polishing 37 and the chemical action of the polishing agent 39.

Unlike the surfaces of wafers in a blank state, the surfaces of wafers that have semiconductor integrated circuits formed inside are not flat; in particular, there are usually step differences between portions in which chips are formed and portions in which chips are not formed. Accordingly, in cases where such wafers are polished, there is a need to eliminate local indentations and projections (this is called "local pattern planarity" while polishing the wafer in conformity to large periodic indentations and projections (undulations) of the wafer substrate itself, i.e., uniformly along such indentations and projections (undulations) (this is called "wafer global removal uniformity").

In order to meet such demands, a method has been developed in which a polishing body is formed by pasting together a polishing pad and a soft pad, and this polishing body is used instead of the polishing pad 41 shown in Figure 10. Specifically, as is shown in Figure 11, a polishing body 44 is formed by pasting together a polishing pad 42 and a pad 43 which has a low elastic modulus and a large compressive deformation rate, and this polishing body 44 is attached to the polishing platen 40.

In such a state, when polishing of the type shown in Figure 10 is performed, the pad 43 is caused to undergo compressive deformation by the force that is applied to the large undulation of the wafer 37 via the polishing pad 42, so that the polishing pad 42 also deforms in conformity to this deformation. Accordingly, polishing can be performed in which the amount of polishing is fixed in accordance with the undulation in the surface of the wafer 37. Meanwhile, in the case of local indentations and projections, the deformation of the polishing pad 42 is relatively small; accordingly, such indentations and projections can be removed by polishing.

In recent years, the degree of integration of semiconductor integrated circuits has become increasingly higher; as a result, a wiring rule of 0.1 μm or less has begun to be used. Furthermore, demand for the polishing of system LSIs has increased, and in system LSIs, the distribution of pattern density has become severe. In cases where wafers are polished which thus have patterns determined by a fine wiring rule or patterns with a severe density distribution formed inside, it is difficult to satisfy both the requirements of "wafer global removal uniformity" and the requirements of "local pattern planarity" even if a polishing body of the above-mentioned type is used. Specifically, in the case of such wafers, local indentations and projections tend to be large; accordingly, as a result of the accompanying compressive deformation of the pad 43 and the deformation of polishing pad 42 in conformity to this deformation of the pad 43, it is difficult to ensure "local pattern planarity."

Disclosure of the Invention

The present invention was devised in order to solve such problems. The object of the present invention is to provide a polishing body which can satisfy both the requirements of "wafer global removal uniformity" and the requirements of "local pattern planarity" even in cases where wafers are polished which have patterns that use a wiring rule of 0.1 μm or less or patterns that have a severe density distribution are formed inside, a CMP polishing apparatus using this polishing body, and a semiconductor device manufacturing method using such a CMP apparatus.

The first invention of the present application which is used to achieve the above-mentioned object is a polishing body for a CMP polishing apparatus which is used to polish wafers that have semiconductor integrated circuits formed inside, wherein a polishing pad, a hard elastic member and a soft member are laminated in that order, and the above-mentioned hard elastic member is constructed so that the amount of deformation of this member at the polishing load that is applied during polishing is smaller than the step difference permitted in the above-mentioned wafer in an interval corresponding to the maximum pattern of the above-mentioned semiconductor integrated circuits, and is greater than the TTV permitted in the above-mentioned wafer in the interval corresponding to one chip.

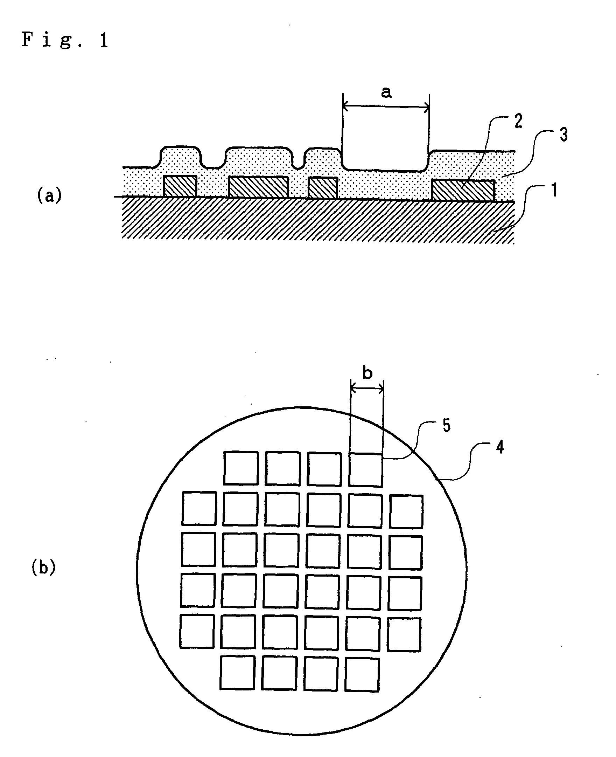

Here, the term "TTV (total thickness variation)" refers to the indentations and projections in the wafer as a whole. The interval corresponding to the maximum pattern of the semiconductor integrated circuits and the interval corresponding to one chip are shown in Figure 1.

Figure 1 (a) shows a sectional view of the wafer prior to polishing. In this figure, 1 indicates the wafer substrate, 2 indicates patterns consisting of circuits and wiring, etc., and 3 indicates an inter-layer insulating layer. The patterns 2 consisting of circuits and wiring are formed on the surface of the substrate 1, and the inter-layer insulating layer 3 is formed on top of this, so that the patterns 2 consisting of circuits and wiring are insulated from each other. The interval corresponding to the maximum pattern of the semiconductor integrated circuits refers to the interval corresponding to the distance $a$ of the recessed part of the inter-layer insulating film 3 that covers the patterns 2 of circuits and wiring that are most separated from each other within one chip. Currently, the interval corresponding to the maximum pattern of such semiconductor integrated circuits is approximately 4 mm.

Figure 1 (b) shows a single wafer, with a plurality of chips 5 being formed on this wafer 1. The interval corresponding to one chip refers to the interval corresponding to one side $b$ in a case where the shape of the chip is square. Currently, this interval is approximately 20 mm. In cases where the shape of the chip is not square, or in cases where chips of different dimensions are formed on one wafer, this interval refers to the distance corresponding to the largest side.

Furthermore, the hard elastic member refers to an elastic member with a Young's modulus of 10,000 Kg/mm$^2$ or greater; metal members may be cited as typical examples. The soft member refers to a member that has a compression rate of 10% or greater when a pressure of 1 Kg/cm$^2$ is applied; chloroprene rubber members containing air bubbles, or elastic nonwoven fabrics, may be cited as typical examples.

In the present means, a hard elastic member is sandwiched between the polishing pad and a soft member. Furthermore, the amount of deformation of this hard elastic member at the load that is applied during polishing is set so that this amount of deformation is smaller than the step difference that is permitted in the above-mentioned wafer in the interval corresponding to the maximum pattern of the above-mentioned semiconductor integrated circuits. Accordingly, since the hard elastic member is not subjected to deformation exceeding the permitted step difference in the interval corresponding to the maximum pattern, "local pattern planarity" is ensured.

Meanwhile, the amount of deformation of the hard elastic member at the polishing load that is applied during polishing is set so that this amount of deformation is greater than the TTV permitted in the wafer in the interval corresponding to one chip. Accordingly, the hard elastic member can deform in conformity to the step difference over the distance corresponding to one chip, and the polishing pad also shows a corresponding deformation in conformity to these step differences, so that a uniform amount of polishing can be performed in accordance with these step differences. Consequently, "wafer global removal uniformity" is ensured.

The second invention of the present application that is used to achieve the above-mentioned object is the polishing body of the first invention, wherein the above-mentioned hard elastic member is constructed from a metal plate that will not dissolve in the polishing agent.

In the above-mentioned first invention, there are no particular stipulations regarding the material of the above-described hard elastic member. Accordingly, a hard plastic or hard rubber, for example, can be used. However, a hard plastic or hard rubber, etc., has a small Young's modulus; accordingly, if such a material is used in the above-described first invention, the thickness of the member must be set at a large value. If this thickness is increased, the degree of parallel orientation of the two surfaces deteriorates; furthermore, irregularities in thermal expansion occur as a result of temperature irregularities caused by the heat generated during polishing, and such irregularities cause a deterioration in planarity.

In the present invention, since the above-described hard elastic member is formed from a metal, the Young's modulus of the hard elastic member is high; accordingly, the thickness of this member can be reduced. Consequently, the degree of parallel orientation of the two surfaces can be maintained at a favorable value, and irregularities in thermal expansion can be reduced, so that the planarity can be maintained at a favorable value. Furthermore, the reason that the type of metal used is limited to a metal that will not dissolve in the polishing agent is as follows: specifically, if the metal dissolves in the polishing agent, there may be cases in which this has a deleterious effect on the semiconductor integrated circuits that are formed on the wafer. Stainless steel and titanium may be cited as examples of metals that will not dissolve in commonly used polishing agents.

The third invention of the present application that is used to achieve the above-mentioned object is the polishing body of the above-mentioned second invention, wherein the above-mentioned metal plate is a stainless steel plate, and the thickness $h$ of this plate is such that 0.1 mm < $h$ < 0.94 mm.

In the present means, in the case of a commonly polished wafer, the effect described in the above-mentioned first means can be obtained; furthermore, the effect described in the above-mentioned second means can also be obtained. In addition, a stainless steel plate is readily available, and is less expensive than other materials.

As will be described in the working configurations later, in cases where it is assumed that the permitted step difference at a wiring rule of 0.35 μm is 0.35 μm and that the TTV is 5 μm, it is assumed that the permitted step difference at a wiring rule of 0.10 μm is 0.10 μm and that the TTV is 2 μm, and it is assumed that the interval corresponding to the maximum pattern of the semiconductor integrated circuits is 4 mm and that the interval corresponding to one chip is 20 mm, a stainless steel thickness $h$ which is such that 0.1 mm < $h$ < 0.94 mm satisfies the conditions fixed by the above-mentioned first invention at a surface pressure of 100 g/cm$^2$ to 700 g/cm$^2$. Accordingly, in the present invention, the thickness of the stainless steel is limited as described above.

The fourth invention of the present application that is used to achieve the above-mentioned object is a polishing body for a CMP polishing apparatus which is used to polish wafers that have semiconductor integrated circuits formed inside, wherein a polishing pad, a hard elastic member and a soft member are laminated in that order, and these parts are constructed so that the combined amount of deformation of the polishing pad, hard elastic member and soft member at the polishing load that is applied during polishing is smaller than the height of the indentations and projections of the above-mentioned maximum pattern in the interval corresponding to the maximum pattern of the above-mentioned semiconductor integrated circuits, and is greater than five times the TTV that is permitted in the above-mentioned wafer.

The term "height of the indentations and projections of the maximum pattern" refers to the depth of the recessed part corresponding to portion $a$ in Figure 1 (a).

In the present means, a hard elastic member is sandwiched between the polishing pad and a soft member. Furthermore, the combined amount of deformation of the polishing pad, hard elastic member and soft member at the polishing load that is applied during polishing is smaller than the height of the indentations and projections of the above-mentioned maximum pattern in the interval corresponding to the maximum pattern of the above-mentioned semiconductor integrated circuits. Accordingly, since the polishing body is not subjected to deformation exceeding the height of the indentations and projections of the maximum pattern in the interval corresponding to the maximum pattern, the step difference between patterns following polishing can be suppressed to a difference that is less than the height of the indentations and projections of the maximum pattern. Consequently, "local pattern planarity" is ensured.

Meanwhile, the combined amount of deformation of the polishing pad, hard elastic member and soft member at the polishing load that is applied during polishing is set so that this amount of deformation is greater than five times the TTV that is permitted in the wafer in the interval corresponding to one chip. Generally, it is known that the amount of deformation of the polishing body must be five times the required TTV or greater if "wafer global removal uniformity" is to be obtained. Accordingly, as a result of the combined amount of deformation of the polishing pad, hard elastic member and soft member being set so that this amount of deformation is greater than five times the TTV that is permitted in the wafer in the interval corresponding to one chip, the polishing pad also deforms in conformity to the step differences in cases where there are step differences in the distance corresponding to one chip. Accordingly, a uniform amount of polishing can be performed in accordance with these step differences. Consequently, "wafer global removal uniformity" is ensured.

The fifth invention of the present application that is used to achieve the above-mentioned object is the polishing body of the above-mentioned fourth invention, wherein the above-mentioned hard elastic member is constructed from a metal plate that will not dissolve in the polishing agent.

In the above-mentioned fourth invention, there are no particular stipulations regarding the material of the above-mentioned hard elastic member. Accordingly, a hard plastic or hard rubber, for example, can be used. However, since hard plastics and hard rubbers, etc., have a small Young's modulus, the thickness must be increased if such materials are used in the above-mentioned fourth means. When the thickness increases, the degree of parallel orientation of the two surfaces deteriorates; furthermore, irregularities in thermal expansion occur as a result of temperature irregularities caused by the heat generated during polishing, and such irregularities cause a deterioration in planarity.

In the present invention, since a metal is used as the material of the above-mentioned hard elastic member, the Young's modulus is high; accordingly, the thickness of the member can be reduced. Consequently, the degree of parallel orientation of the two surfaces can be maintained at a favorable value, and irregularities in thermal expansion can also be reduced, so that the planarity can be maintained at a favorable value. Moreover, the reason that the type of metal used is limited to a metal that will not dissolve in the polishing agent is as follows: specifically, if the metal dissolves in the polishing agent, there are cases in which this has a deleterious effect on the semiconductor integrated circuits that are formed on the wafer. Examples of metals that will not dissolve in commonly used polishing agents include stainless steel and titanium.

The sixth invention of the present application that is used to achieve the above-mentioned object is the polishing body of the fifth invention, wherein the above-mentioned polishing pad consists of a urethane foam material, the above-mentioned metal plate is a stainless steel plate, the thickness of the above-mentioned polishing pad is 0.1 to 3 mm, the thickness of the above-mentioned metal body is 0.05 to 0.6 mm, and the thickness of the above-mentioned soft member is 0.5 to 2.5 mm.

A urethane foam material is superior as the material of a polishing pad; furthermore, a stainless steel plate is easy to obtain, and is less expensive than other materials. In cases where such materials are used, as will be described in the embodiments later, the requirements of both "wafer global removal uniformity" and "local pattern planarity" can be satisfied under advantageous conditions by setting the thicknesses of the polishing pad, metal plate and soft member as described above.

If the thickness of the polishing pad is less than 0.1 mm, the grooves used to conduct the slurry, which are ordinarily formed in the polishing pad, are eliminated. Accordingly, in the present means, the thickness of the polishing pad is limited to a thickness of 0.1 mm or greater. Furthermore, even if the thickness of the polishing pad exceeds 3 mm, no particular advantage is gained, and there is no great difference between such a polishing body and a polishing body in which no metal plate is sandwiched between the other parts as described above; accordingly, in the present means, the thickness of the polishing pad is limited to a thickness of 3 mm or less.

In cases where the thickness of the metal body is less than 0.05 mm, "local pattern planarity" deteriorates as the thickness of the polishing pad is reduced, so that there is no great difference between such a polishing body and a polishing body in which no metal plate is sandwiched between the other parts as described above. Accordingly, in the present means, the thickness of the metal body is limited to a thickness of 0.05 mm or greater. On the other hand, if the thickness of the metal body exceeds 0.6 mm, the limiting conditions of the above-mentioned fourth invention cannot be realized in the case of a wafer with a TTV of 1 $\mu$m; accordingly, in the present means, the thickness of the metal body is limited to a thickness of 0.6 mm or less.

Since the soft member is on the back surface of the metal body, the thickness of the soft member does not greatly affect the "wafer global removal uniformity" or "local pattern planarity." However, since an experiment (simulation) for the purpose of deriving the limits on the above-mentioned respective numerical values in the present invention was conducted in the range of 0.5 to 2.5 mm, the thickness is limited to this range.

The seventh invention of the present application that is used to achieve the above-mentioned object is the polishing body of any of the above-mentioned first through sixth inventions, wherein the above-mentioned soft member has a torsional strength which is such that this member is not damaged when the member rotates with a load applied during polishing.

In the present invention, the above-mentioned soft member has a torsional strength which is such that this member is not damaged when the member rotates with a load applied during polishing; accordingly, polishing can be performed smoothly.

The eighth invention of the present application that is used to achieve the above-mentioned object is the polishing body of any of the above-mentioned first through seventh inventions, wherein the above-mentioned hard elastic member and soft member are fastened by bonding, and the above-mentioned hard elastic member and polishing pad are fastened by vacuum suction.

In the present invention, since the hard elastic member and polishing pad are fastened by vacuum suction, the polishing pad can easily be replaced when the polishing pad becomes worn.

The ninth invention of the present application that is used to achieve the above-mentioned object is the polishing body of any of the above-mentioned first through seventh inventions, wherein the above-mentioned hard elastic member and soft member are fastened by bonding means with a strong peeling strength, and the above-mentioned hard elastic member and polishing pad are fastened by bonding means with a weak peeling strength.

In the present invention, since the above-mentioned hard elastic member and soft member are fastened by bonding means (adhesive agent or two-sided tape, etc.) with a strong peeling strength, and the above-mentioned hard elastic member and polishing pad are fastened by bonding means (adhesive agent or two-sided tape, etc.) with a weak peeling strength, the polishing pad can be peeled from the hard elastic member in a state in which the hard elastic member and soft member remain bonded. Accordingly, the polishing pad can easily be replaced when the polishing pad becomes worn.

The tenth invention of the present application that is used to achieve the above-mentioned object is a CMP polishing apparatus which is used to polish wafers that have semiconductor integrated circuits formed inside, and which has the polishing body of any of the above-mentioned first through ninth inventions.

In the present invention, since the polishing body of one of the above-mentioned first through ninth inventions is used, the effects described in the descriptions of the respective polishing bodies can be obtained.

The eleventh invention of the present application that is used to achieve the above-mentioned object is a CMP polishing apparatus which is used to polish wafers that have semiconductor integrated circuits formed inside, and which has the polishing body of the above-mentioned eighth or ninth invention, wherein the dimensions of the above-mentioned polishing pad are set so that these dimensions are smaller than the dimensions of the wafer that is being polished.

There are two types of CMP polishing apparatuses, i.e., apparatuses in which the dimensions of the polishing pad are larger than the dimensions of the wafer that is being polished, and apparatuses in which the dimensions of the polishing pad are smaller than the dimensions of the wafer that is being polished. In the present invention, the polishing body of the above-mentioned eighth or ninth invention is used in the latter type of apparatus. Accordingly, since the size of the polishing body pad is small, attachment by vacuum suction can easily be accomplished, so that the polishing pad can be securely fastened to the hard elastic member. Furthermore, in such a CMP apparatus, since the polishing pad is small, frequent replacement of the polishing pad is necessary. Accordingly, an especially great effect is obtained by using the polishing body of the above-mentioned eighth or ninth invention, in which replacement of the polishing pad is easy.

The twelfth invention of the present application that is used to achieve the above-mentioned object is a CMP polishing apparatus which is used to polish wafers that have semiconductor integrated circuits formed inside, and which has the polishing body of the above-mentioned seventh invention, wherein the dimensions of the above-mentioned polishing pad are set so that these dimensions are smaller than the dimensions of the wafer that is being polished, and the permissible shear stress of the above-mentioned soft member is greater than 0.5 Kg/cm$^2$.

According to findings obtained by the present inventors, in the case of a CMP polishing apparatus in which the dimensions of the polishing pad are set so that these dimensions are smaller than the dimensions of the wafer that is being polished, the above-mentioned soft member can be endowed with a torsional strength which is such the member is not damaged when the member rotates with a load applied during polishing, by setting the permissible shear stress of the above-mentioned soft member at a value that is greater than 0.5 Kg/cm$^2$.

The thirteenth invention of the present application that is used to achieve the above-mentioned object is a semiconductor device manufacturing method which is characterized in that this method has a process in which the polishing of wafers is performed using the CMP polishing apparatus of any of the abovementioned tenth through twelfth inventions.

In the present invention, wafers can be polished while satisfying the requirements of both "wafer global removal uniformity" and "local pattern planarity," which are required in the polishing of wafers that have semiconductor devices formed inside. Accordingly, a semiconductor exposure apparatus which has a shallow focal depth can be used, and semiconductor devices that have fine patterns can be manufactured with a good yield.

Brief Description of the Drawings

Figure 1 is a diagram which shows the interval corresponding to the maximum pattern of the semiconductor integrated circuits, and the interval corresponding to one chip.

Figure 2 is a diagram which shows an outline of a CMP polishing apparatus and polishing body constituting one example of a working configuration of the present invention.

Figure 3 is a graph which shows the relationship between the surface pressure (polishing pressure) $p$ and the maximum shear stress $\tau_{max}$ of the soft member in one working configuration of the present invention.

Figure 4 is a diagram which shows an outline (sectional view) of a polishing body constituting another working configuration of the present invention.

Figure 5 is a flow chart which shows a semiconductor device manufacturing process constituting one example of a working configuration of the present invention.

Figure 6 is a diagram which shows an outline of a polishing body used in a simulation model in embodiments of the present invention and comparative examples.

Figure 7 is a graph which shows one example of the results obtained in a simulation of the "local pattern planarity."

Figure 8 is a graph which shows one example of the results obtained in a simulation of the "wafer global removal uniformity."

Figure 9 is a schematic diagram of the planarization technique in a semiconductor manufacturing process.

Figure 10 is a diagram which shows an outline of a CMP apparatus.

Figure 11 is a diagram which shows an example in which a polishing body is formed by pasting together a polishing pad and a soft pad.

Best Mode for Carrying out the Invention

Below, examples of working configurations of the present invention will be described with reference to the figures. However, these descriptions do not limit the scope of the present invention.

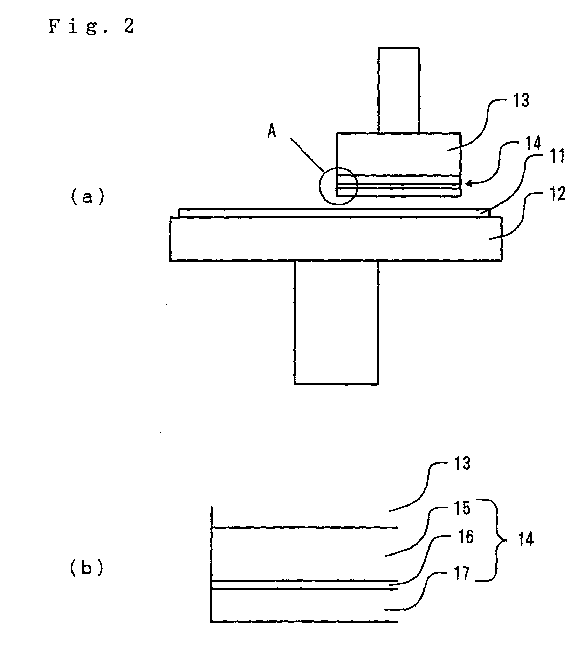

Examples of working configurations of the present invention will be described below with reference to the figures. Figure 2 (a) is a diagram which shows an outline of a CMP polishing apparatus and a polishing body constituting one example of a working configuration of the present invention. Figure 2 (b) is an enlarged view of the portion labeled A in Figure 2 (a). In this working configuration, the size of the polishing pad is smaller than the size of the wafer, unlike the case of the conventional CMP apparatus shown in Figure 10.

The wafer 11 that is the object of polishing is held by a polishing head 12, and rotates together with the polishing head 12. A polishing body 14 is attached to the polishing member 13 by bonding using an adhesive agent or two-sided adhesive tape, etc. As is shown in Figure 2 (b), the polishing body 14 is constructed by laminating a soft member 15, a hard elastic member 16 and a polishing pad 17. In this working configuration, the soft member 15, hard elastic member 16 and polishing pad 17 are bonded by means of an adhesive agent or two-sided adhesive tape, etc.

The polishing body 14 rotates together with the polishing member 13, and swings at the same time; as a result, the polishing pad 17 polishes the entire surface of the wafer 11. In this CMP apparatus as well, a polishing agent is supplied to the area between the wafer 11 and the polishing pad 17; however, this is not shown in the figures.

In the present working configuration, stainless steel is used as the material of the hard elastic member 16. Furthermore, the thickness of the hard elastic member 16 is determined so that the amount of deformation of the hard elastic member 16 caused by the load during polishing is smaller than the step difference that is permitted in the wafer in the interval corresponding to the maximum pattern of the semiconductor integrated circuits, and is larger than the TTV that is permitted in the wafer in the interval corresponding to one chip.

Assuming that the hard elastic member 16 is approximated as a rectangular beam fastened at both ends, that the length of this beam is $L$, the thickness is $h$ and the Young's modulus is $E$, and that the surface pressure $p$ is uniformly applied, then the maximum amount of deformation $w$ can be expressed as follows by universally known calculations for a beam:

$$w = pL^4 / (32\ Eh^3)$$

In a case where the value of the interval corresponding to the maximum pattern is 4 mm, the value of the interval corresponding to one chip is 20 mm, and the device wiring rule is 0.1 μm, then, assuming that the permitted step difference is 0.10 μm and that the TTV is 2 μm, *w* in a case where *L* = 4 mm must be smaller than 0.1 μm, and *w* in a case where *L* = 20 mm must be greater than 2 μm.

Assuming that the surface pressure *p* is 200 g/mm$^2$, and that the Young's modulus *E* of the stainless steel is 21,000 Kg/mm$^2$, then the thickness *h* that satisfies the above-mentioned conditions is a thickness which is such that 0.20 mm < *h* < 0.62 mm. If a hard plastic with a Young's modulus *E* of 400 Kg/mm$^2$ is used instead of stainless steel, the thickness *h* is such that 0.74 mm < *h* < 2.32 mm. If the thickness is too great, there are many inconveniences as described above; accordingly, it is desirable to use a metal which allows a small thickness as the hard elastic member.

Table 1 shows the relationship between the surface pressure during polishing and the limiting conditions on the thickness *h* in a cases where stainless steel is used as the material of the hard elastic member 16. Here, the permitted step difference in the case of a 0.35 μm wiring rule is set at 0.35 μm, and the TTV is set at 5 μm.

Table 1

| Material Stainless steel (*E*= 21,000 Kg/mm$^2$) | Thickness *h* of hard sheet | | | |
|---|---|---|---|---|
| | 0.35 μm wiring rule (Permitted step difference = 0.35 μm; TTV = 5 μm) | | 0.10 μm wiring rule (Permitted step difference = 0.10 μm; TTV = 2 μm) | |
| | *L* = 4 mm | *L* = 20 mm | *L* = 4 mm | *L* = 20 mm |
| Surface pressure load | (*w* < 0.35 μm) | (*w* > 5 μm) | (*w* < 0.1 μm) | (*w* > 2 μm) |
| 100 g/cm$^2$ | 0.10 mm | 0.36 mm | 0.16 mm | 0.49 mm |
| 200 g/cm$^2$ | 0.13 mm | 0.46 mm | 0.20 mm | 0.62 mm |
| 300 g/cm$^2$ | 0.15 mm | 0.52 mm | 0.23 mm | 0.71 mm |
| 400 g/cm$^2$ | 0.16 mm | 0.58 mm | 0.25 mm | 0.78 mm |
| 500 g/cm$^2$ | 0.18 mm | 0.62 mm | 0.27 mm | 0.84 mm |
| 600 g/cm$^2$ | 0.19 mm | 0.66 mm | 0.28 mm | 0.89 mm |
| 700 g/cm$^2$ | 0.20 mm | 0.69 mm | 0.30 mm | 0.94 mm |

It is desirable to use a member which has a large compressive deformation and which tends not to undergo plastic deformation as the soft member 15. For example, a chloroprene rubber, etc., which has air bubbles inside can be used as the material of this member. However, it is desirable that this material have a torsional strength which is such that the member is not damaged when the member rotates with a load applied during polishing.

If this is done, the polishing pad 17 will conform to large undulations corresponding to one chip, so that polishing in which the amount of polishing is fixed can be performed, with the polishing pad 17 showing almost no deformation in the case of local indentations and projections with a spacing corresponding to the maximum spacing of the wiring pattern; accordingly, the requirements of both "wafer global removal uniformity" and "local pattern planarity" can be satisfied.

Furthermore, as a separate approach in this working configuration, stainless steel can be used as the material of the hard elastic member 16, and the thicknesses of the respective members can be determined so that the combined deformation of the polishing pad 17, hard elastic member 16 and soft member 15 caused by the load during polishing is smaller than the height of the indentations and projections of the maximum pattern in the interval corresponding to the maximum pattern of the semiconductor integrated circuits, and greater than five times the TTV permitted in the wafer in the interval corresponding to one chip in this working configuration.

A member which shows a large compressive deformation and which tends not to undergo plastic deformation is desirable as the soft member 15. For example, a chloroprene rubber which has air bubbles inside, or an elastic nonwoven fabric, etc. can be used. However, it is desirable to ensure that the material has a torsional strength which is such that the member will not be damaged when the member rotates with a load applied during polishing.

If this is done, the polishing pad 17 will conform to large undulations corresponding to one chip, so that polishing in which the amount of polishing is fixed can be performed, with the polishing body 14 showing almost no deformation in the case of local indentations and projections with a spacing corresponding to the maximum spacing of the wiring pattern; accordingly, the requirements of both "wafer global removal uniformity" and "local pattern planarity" can be satisfied.

In Figure 2, in a case where the shape of the polishing pad is an annular shape with an external diameter of $D$ and an internal diameter of $d$, assuming that the coefficient of friction between the wafer and polishing pad during polishing is $k$, and that the surface pressure $p$ is uniformly applied to the entire surface of the polishing pad, the maximum torque $T$ and maximum shear stress $\tau_{max}$ applied to the soft member 15 can be expressed as follows by universally known calculations:

$$T = kp\pi(D^3 - d^3) / 12$$

$$\tau_{max} = 16DT/\{\pi(D^4 - d^4)\}$$

$$= 4\ kpD(D_3 - d^3) / \{3(D^4 - d^4)\}$$

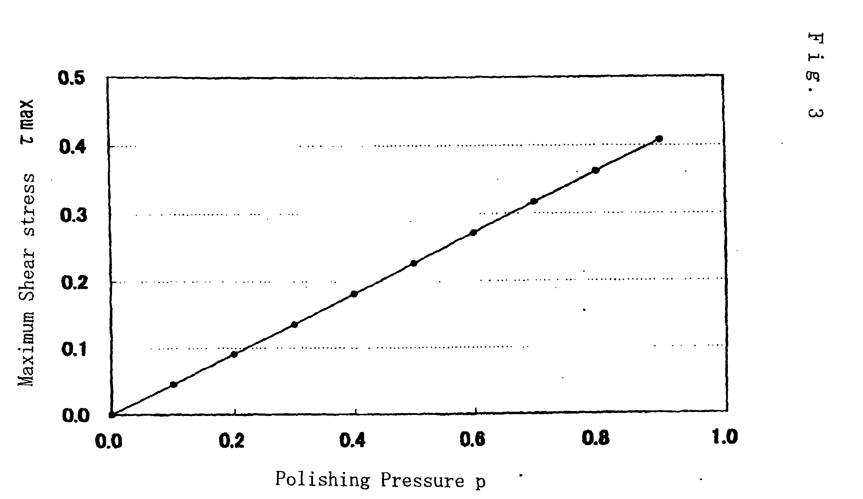

The graph in Figure 3 shows the results obtained when the relationship between the surface pressure (polishing pressure) $p$ (kg/cm$^2$) and the maximum shear stress $\tau_{max}$ (kg/cm$^2$) was determined by calculation in a cases where a polishing pad with an external diameter $D$ of 170 mm and an internal diameter $d$ of 60 mm was used in the CMP polishing apparatus shown in Figure 2, and the coefficient of friction $k$ was 0.35. According to Figure 3, in a CMP polishing apparatus of the type shown in Figure 2, the soft member 15 can be endowed with a torsional strength which is such that the soft member 15 is not damaged under ordinary polishing conditions (polishing pressure: 1.0 Kg/cm$^2$) if the maximum shear stress $\tau_{max}$ permitted in the soft member 15 is greater than 0.5 Kg/cm$^2$.

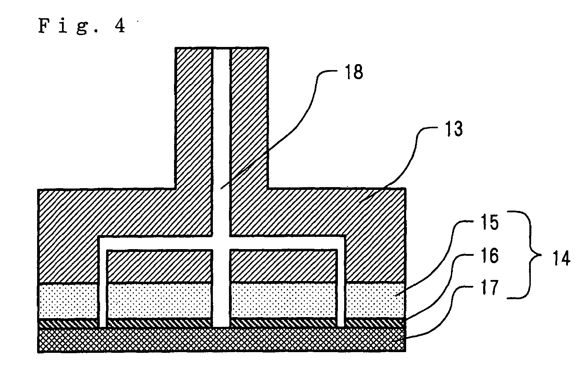

Figure 4 shows an outline (sectional view) of a polishing body constituting another working configuration of the present invention. In Figure 4, constituent elements that are the same as constituent elements shown in Figure 2 are labeled with the same symbols, and a description of such elements is omitted. In the working configuration shown in Figure 4 as well, the basic construction and the materials of the soft member 15, hard elastic member 16 and polishing pad 17 are the same as those shown in Figure 1.

In the working configuration shown in Figure 4, the soft member 15 is bonded to the polishing member 13 by an adhesive agent or two-sided adhesive tape, and the hard elastic member 16 is bonded to the soft member 15 by an adhesive tape or two-sided adhesive tape. However, the hard elastic member 16 and the polishing pad 17 are not bonded. Furthermore, holes 18 are formed which pass through the polishing member 13, soft member 15 and hard elastic member 16, and the polishing pad 17 is fastened to the hard elastic member 16 through vacuum suction by setting the pressure inside these holes 18 at a low pressure that is close to a vacuum in a state in which the polishing pad 17 is pressed against the hard elastic member 16.

If this is done, then the polishing pad 17 can easily be removed merely by releasing the vacuum state in cases where the polishing pad 17 is to be replaced as a result of wear, so that replacement is easy. Especially in cases where a small-diameter polishing pad whose dimensions are smaller than those of the wafer is used, the number of holes 18 required is small, so that a vacuum suction mechanism can easily be provided; accordingly, such a construction is effective. Furthermore, in the case of a small-diameter pad, the frequency of replacement is high; accordingly, the construction shown in Figure 4 is effective in this respect as well.

Furthermore, even in cases where the soft member 15, hard elastic member 16 and polishing pad 17 are bonded only by bonding means such as an adhesive agent or two-sided tape, the polishing pad 17 can easily be peeled from the hard elastic member 16 by using bonding means with a strong peeling strength between the polishing member 13 and soft member 15 and between the soft member 15 and hard elastic member 16, and using bonding means with a weak peeling strength between the hard elastic member 16 and polishing pad 17. As a result, the worn polishing pad 17 can easily be replaced in the same manner as in the above-mentioned working configuration in which a vacuum suction attachment mechanism was provided.

Furthermore, it is desirable that the 180° peeling adhesive strength of the adhesive layers between the polishing member 13 and soft member 15 and between the soft member 15 and the hard elastic member 16 be greater than 1500 g/25 mm, and that the 180° peeling adhesive strength of the adhesive layer between the hard elastic member 16 and the polishing pad 17 be smaller than 1000 g/25 mm.

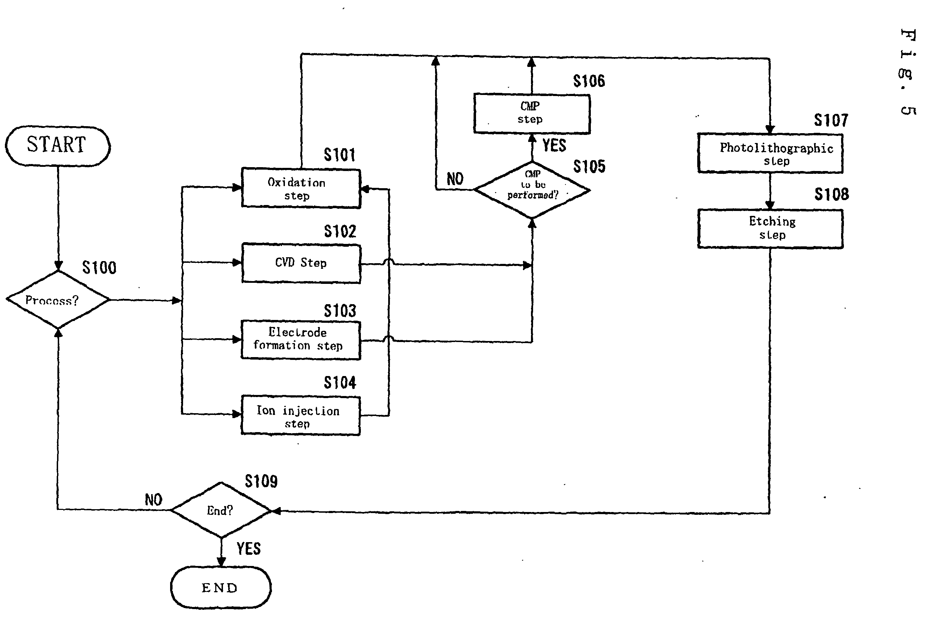

Figure 5 is a flow chart which shows a semiconductor device manufacturing process constituting one example of a working configuration of the present invention. After the semiconductor device manufacturing process is started, the appropriate processing step is first selected in step S100 from the steps S101 through S104 described below. In accordance with this selection, the processing proceeds to one of the steps S101 through S104.

Step S101 is an oxidation step in which the surface of the silicon wafer is oxidized. Step S102 is a CVD step in which an insulating film is formed on the surface of the silicon wafer by CVD, etc. Step S103 is an electrode formation step in which electrodes are formed on the silicon wafer by a process such as vacuum evaporation. Step S104 is an ion injection step in which ions are injected into the silicon wafer.

Following the CVD step or electrode formation step, the processing proceeds to step S105. In step S105, a judgement is made as to whether or not a CMP process is to be performed, and in cases where such a process is to be performed, the processing proceeds to the CMP process of step S106. In cases where a CMP process is not to be performed, step S106 is bypassed. In the CMP process, the flattening of inter-layer insulation films, or the formation of a damascene by the polishing of metal films on the surfaces of semiconductor devices, etc., is performed using the polishing apparatus of the present invention.

Following the CMP step or oxidation step, the processing proceeds to step S107. Step S107 is a photolithographic step. In this photolithographic step, the silicon wafer is coated with a resist, circuit patterns are burned onto the silicon wafer by exposure using an exposure apparatus, and the exposed silicon wafer is developed. Furthermore, the next step S108 is an etching step in which the portions other than the developed resist image are removed by etching, the resist is then peeled away, and the resist that has become unnecessary following etching is removed.

Next, in step S109, a judgement is made as to whether or not all of the necessary steps have been completed. If these steps have not been completed, the processing returns to step S100, and the subsequent steps are repeated, so that circuit patterns are formed on the silicon wafer. If it is judged in step S109 that all of the steps have been completed, the process is ended.

[Examples]

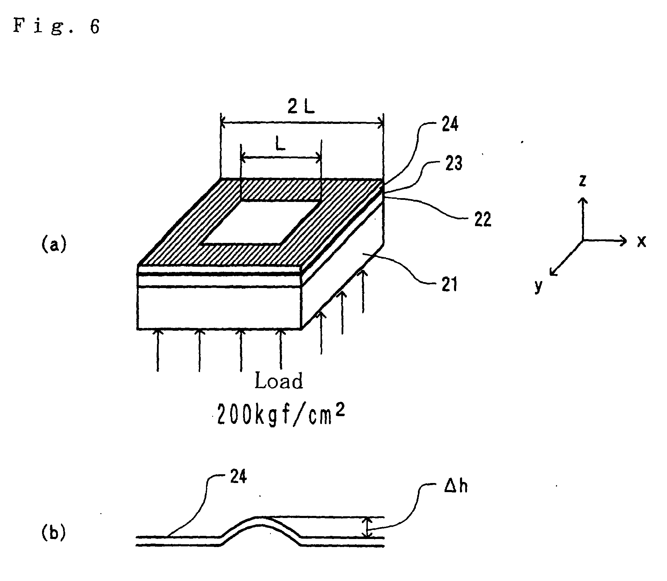

Next, the results of a simulation based on the finite element method will be described for examples of the polishing body of the present invention, and comparative examples. Figure 6 (a) shows the polishing body that was used as the simulation model. A body having the shape of a rectangular solid was envisioned as the polishing body. As is shown in the figure, SUBA22 (an elastic nonwoven fabric) was pasted to a base 21 consisting of Al, and an SUS plate 23 (stainless steel) was laminated on top of this nonwoven fabric. Then, IC1000 24 (a foam urethane) was pasted to the surface of this SUS plate 23. The IC1000 corresponds to the polishing pad, the SUS corresponds to the hard elastic member, and the SUBA corresponds to the soft member. The polishing surface had a square shape with dimensions of 2L on a side, and it was envisioned that this type of polishing body was pressed against the object of polishing with a commonly used pressure of 200 gf/cm$^2$.

For the object of polishing, a hypothetical square hole with dimensions of L on a side was assumed in the central portion of the polishing body. In order to perform an equivalent simulation, a model was used in which the degree of freedom of the surface-most portion of the IC1000 (which is hatched in Figure 6 (a)) was constricted only in the z direction, and only the square portion with dimensions of L on a side formed in the center was displaceable in the z direction as well (i.e., the imaginary square shape with dimensions of L on a side could be recessed into the hole).

Then, the amount of recession of the IC1000 (amount of recession of the pad) $\Delta h$ shown in Figure 5 (b) was calculated with the thicknesses of the IC1000, SUS plate and SUBA varied. Furthermore, in a case where the "wafer global removal uniformity" was evaluated with the thickness of the Al fixed at 15 mm, L was set equal to 20 mm. This envisioned an extreme case in which the entire pattern of a typical chip constituted a recessed part. Furthermore, when the "local pattern planarity" was evaluated, L was set equal to 4 mm. The reason for this is that the envisioned maximum pattern interval was approximately 4 mm.

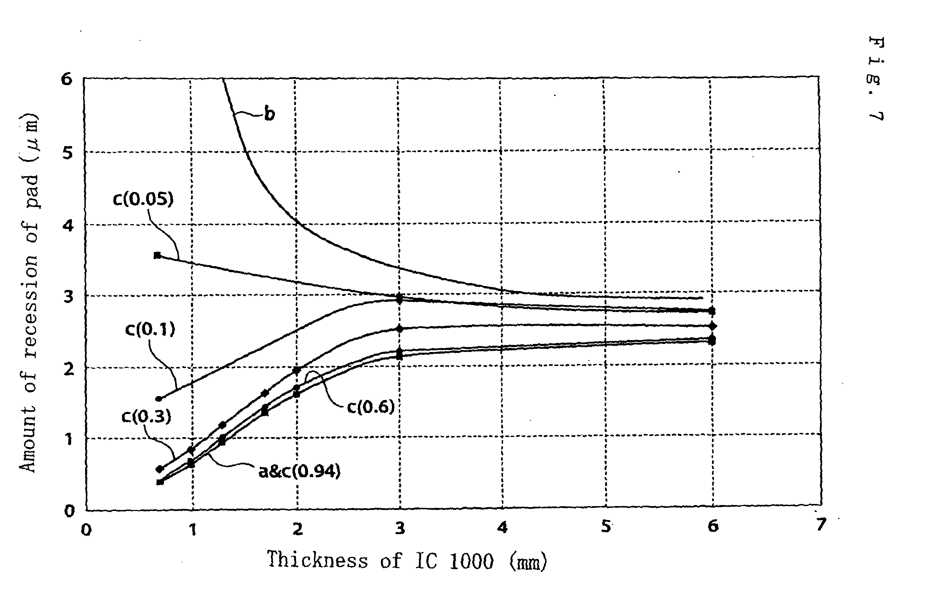

Figure 7 shows one example of the results of a simulation of the "local pattern planarity." The horizontal axis in the figure shows the thickness of the IC1000, and the vertical axis shows the amount of recession of the IC1000 (amount of recession of the pad) $\Delta h$. Among the curves shown in the figure, the curve indicated by *a* represents data for a case (single layer) in which the IC1000 was pasted directly to the Al base without installing an SUS plate or SUBA. The curve indicated by *b* represents data for a case (two layers) in which an SUBA was pasted to the Al base, and the IC1000 was pasted directly to the SUBA without installing an SUS plate. The curves indicated by *c*(*x*) represent data for cases (three layers) in which an SUBA was pasted to the Al base, an SUS plate with a thickness of *x* mm was pasted to the surface of the SUBA, and the IC1000 was pasted to the surface of the SUS plate. In cases where an SUBA was installed, the thickness was 1.27 mm in all instances.

Furthermore, no difference was seen between *c*(0.94) and *a* in the effective numerical range of the present calculations; accordingly, the curves of *c*(0.94) and *a* coincide in the graph shown in Figure 7. Consequently, these coinciding curves are indicated as *a&c*(0.94).

"Local pattern planarity" is considered to be improved as the amount of recession of the pad is smaller. In the case of a single layer, extremely good data are obtained. On the other hand, in the case of two layers, the amount of recession of the pad is large, and shows an abrupt increase especially in cases where the thickness of the IC1000 is small, which is undesirable. In the case of three layers, the amount of recession of the pad decreases as the thickness of the SUS plate is increased.

It is seen from this figure that it is desirable to set the thickness of the SUS plate at 0.05 mm or greater, as a range in which data obtained when three layers are used are clearly superior to those obtained in the case of two layers. Furthermore, in cases where three layers are used, it is seen that the amount of recession of the pad becomes saturated when the thickness of the IC1000 exceeds 3 mm, so that it is desirable to set this thickness at 3 mm or less.

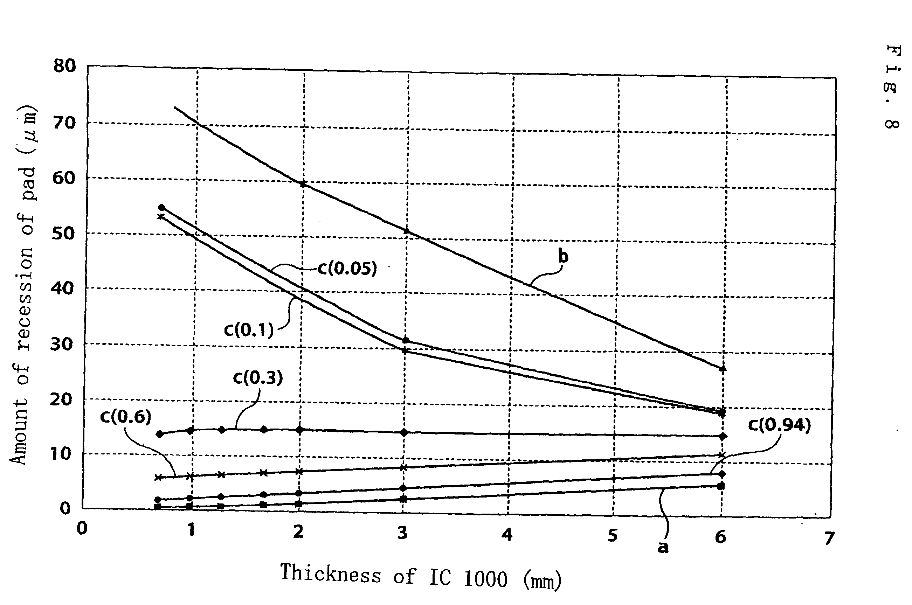

Figure 8 shows one example of the results of a simulation of "wafer global removal uniformity." The horizontal axis and vertical axis of the figure and the meanings of the curves in the figure are the same as in Figure 7. Furthermore, in cases where an SUBA was installed, the thickness was 1.27 mm in all instances.

In the case of "wafer global removal uniformity," it is considered desirable that the amount of recession of the pad be large; generally, an amount that is approximately five times the TTV is considered to be necessary. Accordingly, in cases where 1 μm is used as the currently accepted TTV, it is considered necessary that the amount of recession of the pad be 5 μm or greater.

Considering a case in which the thickness of the IC1000 is set at 3 mm or less as described above, this standard clearly cannot be satisfied in the case of a single layer, and even in cases where three layers are formed, this standard cannot be satisfied if the thickness of the IC1000 is small, unless the thickness of the SUS plate is 0.6 mm or less. Accordingly, it is desirable that the thickness of the SUS plate be set at 0.6 mm or less.

The data shown in Figures 7 and 8 are data that were obtained in a case where the thickness of the SUBA was set at 1.27 mm as described above. In the simulation, the thickness of the SUBA was varied from 0.5 to 2.5 mm; however, the variation in the amount of recession of the pad caused by this variation in thickness was small. It is thought that the reason for this is as follows: specifically, since SUBA is a soft material, there is little effect on the amount of recession of the pad even if the thickness of the SUBA is varied.

Industrial Applicability

The polishing body and CMP polishing apparatus of the present invention can be used to polish wafers that have semiconductor circuit patterns in a semiconductor device manufacturing process. Furthermore, the semiconductor manufacturing method of the present invention can be used to manufacture semiconductor devices that have fine patterns.

**Claims**

1. A polishing body for a CMP polishing apparatus which is used to polish wafers that have semiconductor integrated circuits formed inside, wherein a polishing pad, a hard elastic member and a soft member are laminated in that order, and the above-mentioned hard elastic member is constructed so that the amount of deformation of this member at the polishing load that is applied during polishing is smaller than the step difference permitted in the above-mentioned wafer in an interval corresponding to the maximum pattern of the above-mentioned semiconductor integrated circuits, and is greater than the TTV permitted in the above-mentioned wafer in the interval corresponding to one chip.

2. The polishing body according to Claim 1, wherein the above-mentioned hard elastic member is constructed from a metal plate that will not dissolve in the polishing agent.

3. The polishing body according to Claim 2, wherein the above-mentioned metal plate is a stainless steel plate, and the thickness *h* of this plate is such that 0.1 mm < *h* < 0.94 mm.

4. A polishing body for a CMP polishing apparatus which is used to polish wafers that have semiconductor integrated circuits formed inside, wherein a polishing pad, a hard elastic member and a soft member are laminated in that order, and these parts are constructed so that the combined amount of deformation of the polishing pad, hard elastic member and soft member is smaller than the height of the indentations and projections of the above-mentioned maximum pattern in the interval corresponding to the maximum pattern of the above-mentioned semiconductor integrated circuits, and is greater than five times the TTV that is permitted in the above-mentioned wafer.

5. The polishing body according to Claim 4, wherein the above-mentioned hard elastic member is constructed from a metal plate that will not dissolve in the polishing agent.

6. The polishing body according to Claim 5, wherein the above-mentioned polishing pad consists of a urethane foam material, the above-mentioned metal plate is a stainless steel plate, the thickness of the above-mentioned polishing pad is 0.1 to 3 mm, the thickness of the above-mentioned metal body is 0.05 to 0.6 mm, and the thickness of the above-mentioned soft member is 0.5 to 2.5 mm.

7. The polishing body according to any one of Claims 1 through 6, wherein the above-mentioned soft member has a torsional strength which is such that this member is not damaged when the member rotates with a load applied during polishing.

8. The polishing body according to any one of Claims 1 through 7, wherein the above-mentioned hard elastic member and soft member are fastened by bonding, and the above-mentioned hard elastic member and polishing pad are fastened by vacuum suction.

9. The polishing body according to any one of Claims 1 through 7, wherein the above-mentioned hard elastic member and soft member are fastened by bonding means with a strong peeling strength, and the above-mentioned hard elastic member and polishing pad are fastened by bonding means with a weak peeling strength.

10. A CMP polishing apparatus which is used to polish wafers that have semiconductor integrated circuits formed inside, and which has the polishing body according to any one of Claims 1 through 9.

11. A CMP polishing apparatus which is used to polish wafers that have semiconductor integrated circuits formed inside, and which has the polishing body according to Claim 8 or 9, wherein the dimensions of the above-mentioned polishing pad are set so that these dimensions are smaller than the dimensions of the wafer that is being polished.

12. A CMP polishing apparatus which is used to polish wafers that have semiconductor integrated circuits formed inside, and which has the polishing body according to Claim 7, wherein the dimensions of the above-mentioned polishing pad are set so that these dimensions are smaller than the dimensions of the wafer that is being polished, and the permissible shear stress of the above-mentioned soft member is greater than 0.5 Kg/cm$^2$.

13. A semiconductor device manufacturing method which is **characterized in that** this method has a process in which the polishing of wafers is performed using the CMP polishing apparatus according to any one of Claims 10 through 12.

Fig. 1

(a)

(b)

Fig. 2

(a)

(b)

Fig. 3

Maximum Shear stress $\tau$ max

Polishing Pressure p

Fig. 4

Fig. 5

START → S100 Process? → S101 Oxidation step, S102 CVD Step, S103 Electrode formation step, S104 Ion injection step → S105 CMP to be performed? — YES → S106 CMP step; NO → S107 Photolithographic step → S108 Etching step → S109 End? — YES → END; NO → S100

Fig. 6

(a)

Load
200kgf/cm²

(b)

Fig. 7

Fig. 8

EP 1 408 538 A1

Fig. 9

(a)

32

34

31

(b)

33

32

34

31

Fig. 10

Fig. 11

## INTERNATIONAL SEARCH REPORT

| International application No. |
|---|
| PCT/JP02/06780 |

| A. CLASSIFICATION OF SUBJECT MATTER |
|---|
| Int.Cl⁷ H01L21/304 |

According to International Patent Classification (IPC) or to both national classification and IPC

| B. FIELDS SEARCHED |
|---|

Minimum documentation searched (classification system followed by classification symbols)
Int.Cl⁷ H01L21/304, B24B37/00

Documentation searched other than minimum documentation to the extent that such documents are included in the fields searched
| Jitsuyo Shinan Koho | 1922–1996 | Toroku Jitsuyo Shinan Koho | 1994–2002 |
| Kokai Jitsuyo Shinan Koho | 1971–2002 | Jitsuyo Shinan Toroku Koho | 1996–2002 |

Electronic data base consulted during the international search (name of data base and, where practicable, search terms used)

| C. | DOCUMENTS CONSIDERED TO BE RELEVANT | |
|---|---|---|
| Category* | Citation of document, with indication, where appropriate, of the relevant passages | Relevant to claim No. |
| A | JP 9-50974 A (Sony Corp.),<br>18 February, 1997 (18.02.97),<br>Full text; Figs. 1 to 6<br>(Family: none) | 1–13 |
| A | EP 845218 A2 (Sumitomo Metal Industries, Ltd.),<br>16 June, 1998 (16.06.98),<br>Full text; Figs. 1 to 16<br>& JP 10-156705 A      & US 6077153 A | 1–13 |
| A | JP 11-156701 A (NEC Corp.),<br>15 June, 1999 (15.06.99),<br>Full text; Figs. 1 to 8<br>(Family: none) | 1–13 |

☐ Further documents are listed in the continuation of Box C.      ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 08 October, 2002 (08.10.02) | 22 October, 2002 (22.10.02) |

| Name and mailing address of the ISA/ | Authorized officer |
|---|---|
| Japanese Patent Office | |
| Facsimile No. | Telephone No. |

Form PCT/ISA/210 (second sheet) (July 1998)